# EUROPEAN PATENT APPLICATION

(11) **EP 4 641 240 A1**
(43) Date of publication of application: **29.10.2025**
(21) Application number: 24183882.0
(22) Date of filing: 24.06.2024
(51) Int. Cl.: G01R 33/38, G01R 33/3815

(54) **CONTINUOUS COLUMN SUPPORT FOR CRYOGENIC STRUCTURE IN MAGNETIC RESONANCE IMAGING DEVICE**

(30) Priority: 25.04.2024 US 202463638470 P
(71) Applicant: Koninklijke Philips N.V., 5656 AG Eindhoven (NL)
(72) Inventor: ANDREWS, Benjamin James, Eindhoven (NL); JEWETT, Jason Winfred, Eindhoven (NL)
(74) Representative: Philips Intellectual Property & Standards

(57) **Abstract**

A magnetic resonance imaging (MRI) magnet includes a vacuum container (10); a cryogenic structure (22) comprising superconducting windings (12), the cryogenic structure disposed inside the vacuum container; and support columns (40) connecting the cryogenic structure to an inner side wall of the vacuum container. In some examples, the support columns are under a first compressive load (L) when an interior of the vacuum container is at a vacuum pressure.

## Description

### TECHNICAL FIELD

The following relates generally to the magnetic resonance imaging (MRI) arts, magnet arts, cryogenic container arts, and related arts.

### BACKGROUND

In some superconducting MRI magnets, the cryogenic structure (i.e., a part of the magnet that is cooled to a cryogenic temperature) is surrounded by a vacuum chamber to control heat transfer into the cryogenic structure, allowing the cryogenic structure to be maintained at the cryogenic temperature indefinitely. The vacuum chamber is supported on the ground and is at approximately room temperature, and the cryogenic structure is supported within the vacuum chamber (referred to as an outer vacuum container, or OVC) such that minimal heat transfer occurs to the cryogenic structure and such that the position of the cryogenic structure remains fixed during handling, transport, and operation of the MRI system.

Current methods of supporting the cryogenic structure within the vacuum chamber employ a system of fiberglass members (which have low thermal conductivity, high tensile strength, and moderate stiffness), which are pre-stretched during assembly so that they are always in tension (as is common for applications of composite materials). Multiple such tensile fiberglass members are used to support the cryogenic structure, frequently separated broadly into assemblies providing radial constraint (i.e., a radial suspension system) and assemblies providing axial constraint (i.e., an axial suspension system).

Some current methods have anchored both the radial and axial tensile suspension assemblies near the outer edge of the OVC, allowing the majority of the suspension loads to be reacted along the OVC. In sealed (sometimes referred to as helium free) magnets, the axial suspension system attachment points may be moved towards the radial center of the OVC. This causes the axial suspension loads to be reacted upon by toroidal flat plates on the ends of the magnet, which are structurally compliant. Additionally, the endplates additionally carry the vacuum load (vacuum inside the OVC, atmospheric pressure outside), and the combination of these loads requires the use of thicker endplates and (in some cases) additional structural reinforcement of this portion of the endplate.

The following discloses certain improvements to overcome these problems and others.

### SUMMARY

In some nonlimiting illustrative embodiments, a magnetic resonance imaging (MRI) magnet includes a vacuum container; a cryogenic structure comprising superconducting windings, the cryogenic structure disposed inside the vacuum container; and support columns connecting the cryogenic structure to an inner side wall of the vacuum container.

In some nonlimiting illustrative embodiments, a method of assembling a MRI magnet includes with a vacuum container at atmospheric pressure, disposing a cryogenic structure comprising superconducting windings inside the vacuum container with support columns connecting the cryogenic structure to an inner side wall of the vacuum container; and evacuating the vacuum container to form a vacuum inside the vacuum container, wherein a pressure difference between an outside of the vacuum container and the vacuum inside the vacuum container imposes a compressive load on the support columns.

In some nonlimiting illustrative embodiments, an MRI magnet includes a vacuum container; a cryogenic structure comprising superconducting windings, the cryogenic structure disposed inside the vacuum container; and hollow support columns connecting the cryogenic structure to an inner side wall of the vacuum container.

One advantage resides in providing a magnet for an MRI device with a reduced cost and complexity of a seal vacuum container.

Another advantage resides in providing columns to support a cryogenic container in a vacuum chamber for transport of an MRI device.

Another advantage resides in providing columns in compression to position a cryogenic container in a vacuum chamber with the cryogenic chamber not resting on a bottom surface of the vacuum chamber.

Another advantage resides in applying a pre-load compression to columns to support a cryogenic container in a vacuum chamber for transport of an MRI device.

A given embodiment may provide none, one, two, more, or all of the foregoing advantages, and/or may provide other advantages as will become apparent to one of ordinary skill in the art upon reading and understanding the present disclosure.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
Fig. 1 diagrammatically illustrates a sectional view of a portion of a magnetic resonance imaging (MRI) device according to one aspect.
Fig. 2 schematically illustrates a cryogenic structure supported of the MRI device of FIGURE 1 within a vacuum chamber.
Fig. 3 diagrammatically illustrates a column shown in Fig. 2.
Fig. 4 illustrates a flowchart of a method of installing the MRI device of Fig. 1 in the vacuum container of FIGURE 2.

### DETAILED DESCRIPTION

Replacing the typical axial suspension configuration (which can be pre-loaded in tension, thus increasing the load on the endplates when combined with the vacuum load) with a column-type configuration loaded in compression, as disclosed herein, enables the vacuum load to produce additional compressive force to complement a compressive pre-load on the support columns, and reduces the net endplate load (since the supporting columns act as a mid-span support for the endplate). By reducing this load, additional structural reinforcement of the endplate can be avoided, and endplate thickness can be reduced, which reduces cost, weight, and labor.

The disclosed MRI device, according to some embodiments disclosed herein, includes two or more support columns made of thermally insulating structural material and placed in compression to support the cryogenic structure inside a vacuum chamber by continuous contact with both the outer container and the cryogenic structure. The columns can take any shape necessary to provide the required stiffness, thermal isolation, stress, and buckling resistance. Continuous contact is accomplished by preloading the columns in compression at assembly through a threaded socket tightened to specified torque. This concept takes advantage of the external atmospheric pressure load (due to the interior of the container being under vacuum) and inherent compliance of the container walls to provide adequate compliance for nominal and off-nominal loading conditions. In other words, as a vacuum is drawn in the vacuum chamber, the compliance of the walls of the vacuum chambers allows the walls to move inward under the atmospheric pressure outside the vacuum chamber (as the drawing of the vacuum removes the countervailing atmospheric pressure inside the vacuum chamber), thus adding compressive load to the support columns.

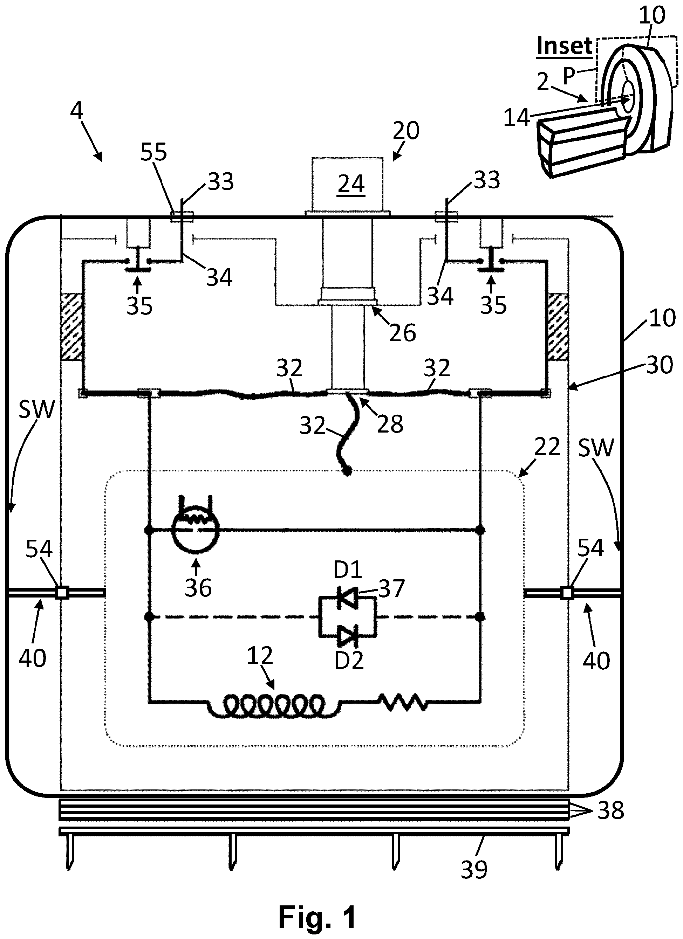

With reference now to Fig. 1, sectional view 4 is shown of a portion of a magnetic resonance imaging (MRI) device 2. The Inset of Fig. 1 illustrates the section plane P through a portion of a housing of the MRI device 2, which contains superconducting windings (i.e., coils) 12 of the main magnet of the MRI device 2. When energized by an electric current flowing therethrough, the superconducting windings 12 produce a static (B0) magnetic field in a bore 14 (see Inset) of the MRI device 2. As seen in the Inset, the housing is generally cylindrical and surrounds the bore 14. The static (B0) magnetic field produced by the energized superconducting windings 12 produces the B0 field typically oriented parallel (or antiparallel) with the axis of the bore 14. The nominal (i.e., design-basis) strength of the static (B0) magnetic field may, for example, be in a range of 0.2 Tesla to 7 Tesla depending on the MRI device design, although B0 field strengths above or below this range are also contemplated.

The housing is (or includes) a vacuum container 10 configured to thermally isolate the superconducting windings 12 so the superconducting windings 12 are maintained below the superconducting transition temperature (at the operational electric current) of the superconducting material making up the superconducting windings 12. In some embodiments, the superconducting material is a high temperature superconductor (HTS). The vacuum container 10 is a container wherein the pressure inside the container is much less than the pressure outside the container. Outside the vacuum container 10 is typically air at room temperature (300K). Inside the vacuum container 10 is a vacuum (said another way, during operation of the magnet the vacuum container 10 is evacuated). A cryocooler (e.g., a cold head) 20 is operative to cool a diagrammatically indicated cryogenic structure 22 that includes the superconducting windings 12. Although not shown, the cryogenic structure 22 typically includes additional components, such as a former of copper, copper alloy, or another metal or other material on which the superconducting windings 12 are wound or otherwise supported, and endplates that serve as support connection points. The illustrative cryocooler 20 is a two-stage refrigerator with a compressor motor 24 that cyclically compresses and decompresses gas helium or another suitable working fluid to cool a first stage 26 of the cryocooler 20 to a first stage temperature that is below room temperature, and to further cool a second stage 28 of the cryocooler 20 to a lower second stage temperature that is below the superconducting transition temperature (at the operational electric current) of the superconducting material making up the superconducting windings 12. The first stage 26 of the cryocooler 20 is thermally connected to cool a radiation shield 30 disposed inside the vacuum container 10 to about the first stage temperature. During operation of the magnet, the thusly cooled radiation shield 30 reduces radiative thermal losses from the cryogenic structure 22. The second stage 28 of the cryocooler 20 is thermally connected with the cryogenic structure 22 by one or more thermal links 32.

The magnet windings 12 have terminal connections 33 located outside of the vacuum container 10, which are at room temperature (e.g., ~300K). An electrical conductor 34 extends from each terminal connection 33 into the vacuum container 10 through a vacuum feedthrough 55. The terminal connections 33 and conductors 34 are typically made of copper or a copper alloy or the like, and are not superconducting during operation of the magnet. To charge the superconducting windings 12 with an electric current for generating the static B0 magnetic field, a magnet power supply (not shown) is connected with the terminal connections 33 to deliver electric current to the superconducting windings 12 via the electrical conductors 34. However, during operation of the magnet, connection of the magnet power supply with the superconducting windings 12 is undesirable as it presents a thermal path from the outside of the vacuum container 10 (which is at room temperature, e.g., ~300K) to the cryogenic structure 22 that is to be kept below the superconducting transition temperature of the superconducting windings 12. To enable automated connection/disconnection of the magnet power supply to/from the superconducting windings 12, electromagnetically actuated lead contactors 35 are provided to connect/disconnect the respective terminal connections 33. This is merely a nonlimiting illustrative approach, and other techniques for charging the superconducting current in the magnet windings 12 are contemplated, such as employing a temporary electrical feed that is removed after the superconducting current is established.

With continuing reference to Fig. 1, a persistent current switch 36 suitably includes a conductor made of a superconducting material, and a neighboring non-superconducting resistive heating coil. In the absence of current flowing through the resistive heating coil, the conductor is superconducting and thus supports flow of superconducting electric current through the superconducting loop that includes the superconducting windings 12 and the persistent current switch 36 connected in parallel therewith. This is the closed state of the persistent current switch 36. On the other hand, if electric current is flowed through the resistive heating coil of the persistent current switch 36 then it heats the conductor causing the latter to transition from the superconducting state to the non-superconducting state, thus opening the persistent current switch 36. In the operational state of the magnet, the persistent current switch 36 is closed to enable electrical current to circulate around the superconducting loop including the superconducting coils 12 and the closed persistent current switch 36; whereas, during magnet ramp-up the persistent current switch 36 is open to ensure that the ramping current flows only through the superconducting windings 12.

The magnet of the MRI device 2 further includes a quench protection circuit 37 that is configured to provide quench protection for the magnet. A quench occurs if the temperature of the cryogenic structure 22 exceeds the superconducting transition temperature of the superconducting material of the superconducting windings 12 so that the superconducting windings transition back to their non-superconducting state. Quenching can occur, for example, due to loss of sufficient cooling of the cryogenic structure 22 by the cryocooler 20, or due to an increase in the electric current circulating in the superconducting windings 12. (This latter quenching mechanism is due to reduction in the transition temperature as the magnetic field induced by the circulating current increases). The illustrative quench protection circuit 37 includes antiparallel diodes D1 and D2 electrically connected across the magnet 12. If the superconducting windings 12 transitions out of the superconducting state, a large voltage is placed across the illustrative quench protection circuit 37 causing electrical current to flow through the quench protection circuit 37 where the energy is rapidly dissipated in the diodes D1, D2. It is to be appreciated that the illustrative quench protection circuit 37 including the antiparallel diodes D1 and D2 is one nonlimiting illustrative example, and that a different type of quench protection circuit can be employed. As another nonlimiting example (not shown), the quench protection circuit 37 could be configured as a persistent switch that diverts the magnet current into a network of heaters placed against the superconducting coils when a quench is detected.

As further shown in Fig. 1, the MRI device 2 may include various ancillary components, such as an illustrative set of magnetic field gradient coils 38 for encoding NMR induced in a patient or other MRI imaging subject disposed in the bore 14, and/or a whole-body radiofrequency (RF) coil 39 for exciting the NMR in the patient or other subject. The RF coil 39 may, for example, be a birdcage coil or a transverse electromagnetic (TEM) coil, as two nonlimiting illustrative examples, and may optionally also include an RF shield (not shown). The gradient coils 38 and optional RF coil 39 are suitably arranged concentrically in the bore 14.

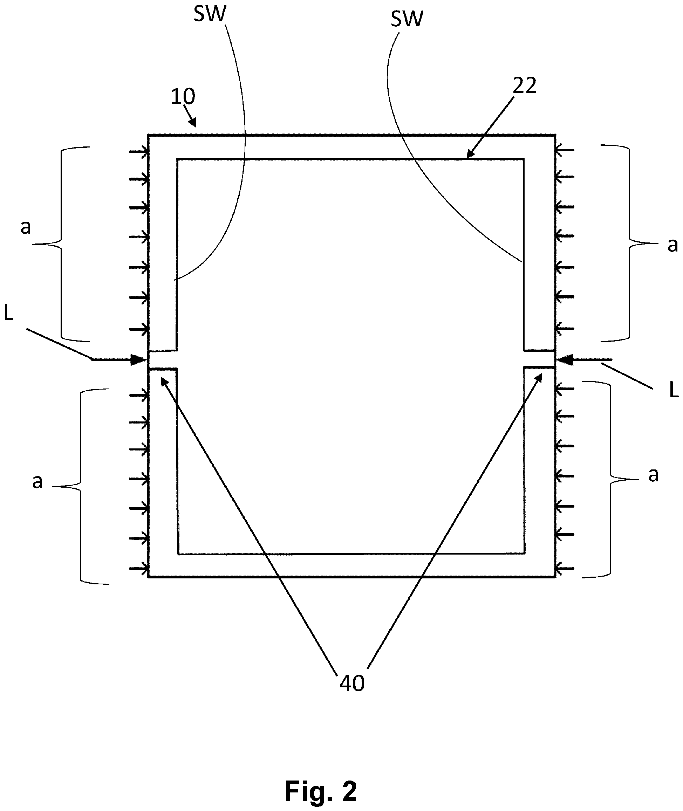

With continuing reference to Fig. 1 and further reference now to Fig. 2, support columns 40 connecting the cryogenic structure 22 to an inner side wall SW of a vacuum container 10 is schematically shown. Fig. 1 shows the support columns in the context of the overall assembly, while Fig. 2 provides a simplified diagram including diagrammatic representations of the vacuum container 10 and cryogenic structure 22. Each column 40 comprises a single structural member connected to the inner side wall SW of the vacuum container 10 and the cryogenic structure 22 to provide stability of the cryogenic structure 22 within the vacuum container 10. Each column 40 allows for minimal heat transfer through or along a length thereof. Each column 40 can have device placed between the two ends to allow some of the heat load to be transferred to the first stage 26 of the cryocooler 20.

Each column 40 is under an uninterrupted (i.e., continuous) compressive load (illustrated in Fig. 2 with arrows labeled "L") to prevent damage to the column 40 or surrounding structures that could occur if one or more of the columns 40 were to unload and separate. For example, the support columns 40 are under a first compressive load when an interior of the vacuum container 10 is at a vacuum pressure. The support columns 40 are under a second compressive load (also referred to herein as pre-compression) when the interior of the vacuum container 10 is at atmospheric pressure (illustrated in Fig. 2 with arrows labeled "a"). The second compressive load is less than the first compressive load, for example, at least 1.5:1, and in particular 2:1 in some nonlimiting illustrative embodiments. The reason that the second (pre-compression) load with the vacuum container 10 at atmosphere is lower than the first compressive load is because with the vacuum container 10 at atmosphere there is a countervailing outward atmospheric pressure inside the vacuum container 10 that cancels the inward atmospheric pressure outside the vacuum container 10. When vacuum is drawn inside the vacuum container 10, the countervailing outward atmospheric pressure inside the vacuum container 10 is removed, and compliance of the walls of the vacuum container 10 permit some inward bowing of the walls due to the now unbalanced inward atmospheric pressure from outside the vacuum container 10.

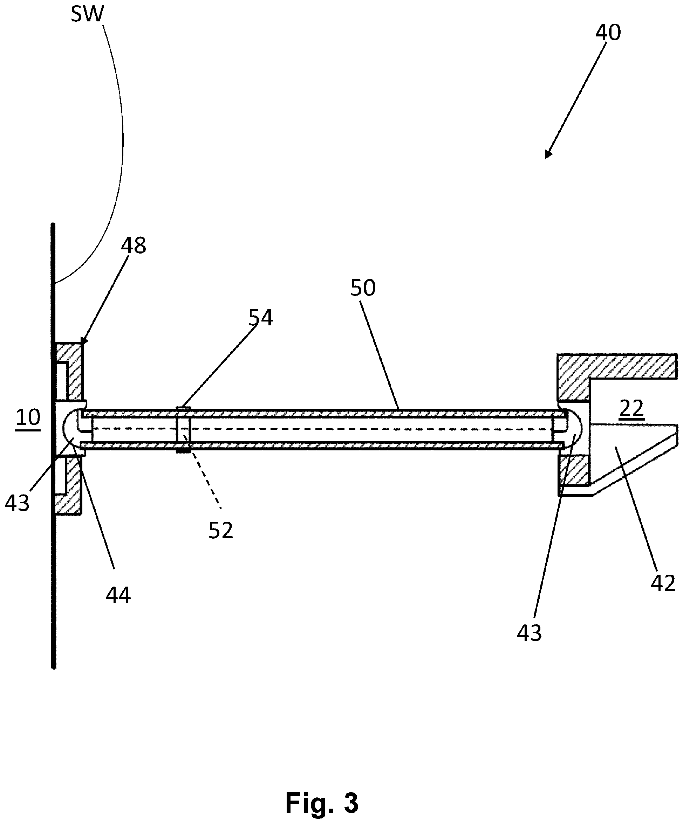

With continuing reference to Figs. 1 and 2, Fig. 3 shows an example of the support columns 40 (only one of which is shown in Fig. 3 for conciseness). As described in more detail below, the combination of continuous, pre-compressed, insulating columns 40 and a heat removal system that is anchored to compliant endplates is a system capable of balancing constraint and flexibility of the cryogenic structure 22, while reducing end plate loads and permitting minimal additional heat transfer to the cryogenic structure 22.

As shown in Fig. 3, the cryogenic structure 22 has sockets 42 into which ends of the support columns 40 proximate to the cryogenic structure 22 engage. The end proximate to the cryogenic structure 22 of each support column 40 comprises a cap 43 sized and dimensioned to fit into the corresponding socket 42 of the cryogenic structure 22. Some dynamic motion of the cryogenic structure 22 is permitted during handling and transport of the vacuum container 10. Therefore, the support columns 40 advantageously permit enough movement that the columns 40 are not over-stressed or damaged by this movement, which is accomplished with a ball and socket joint comprising the cap 43 and the corresponding socket 42 of the cryogenic structure 22. The sockets 42 can be made, for example, from stainless steel. The ends of the column 40 are fitted with the caps 43, which are made of brass to avoid galling with the stainless steel material of the sockets 42. Joint performance can also optionally be improved by adding a lubricating substance (such as graphite powder) into the joint. The caps 43 optionally have vent holes drilled in them to prevent trapped gas in the column assemblies. The caps 43 can have a hemispherical shape, or any other suitable shape that fits within a shape of the corresponding socket 42 of the cryogenic structure 22.

A pair of sockets 44 is disposed on the inner side wall SW of the vacuum container 10. A pair of brackets 48 are mounted on the inner side wall SW of the vacuum container 10. The brackets 48 can be made, for example, from stainless steel. The sockets 44 are rotatably mounted in the brackets 48. The sockets 44 can, for example, include threads to mate with corresponding threads of the brackets 48. The mating fixture for the cap 43 is the bracket 48 welded to the cryogenic structure 22 with a socket 44 in it (for example, a hemispherical socket). The sides of the socket 44 are tapered to allow the columns 40 to move in the socket 44 without colliding with the edges. On the vacuum container 10, there is a welded fixture attached to the vacuum container 10 with a threaded hole in the center. The separate socket piece 44 is threaded into this hole in the bracket 48. This threaded joint allows for expected manufactured variability while maintaining a consistent pre-compression of the columns 40.

As shown in Fig. 3, the support column(s) 40 are hollow, for example by having a hollow lumen 50. Each column 40 includes a plug 52 disposed in the lumen 50 of the hollow support column 40 to block radiative heat transfer through the lumen 50 of the hollow support column 40. A hollow tube geometry was selected for the compressive columns 40 due to its excellent buckling performance. A person having ordinary skill in the art will appreciate that other geometric arrangements may be used in accordance with the scope of this disclosure.

Each support column 40 includes a heat transfer device 54 disposed on an outer surface of the support column 40 and thermally connected with the first cold stage 26 of the cryocooler 22. In illustrative Fig. 1, this is accomplished by the heat transfer device 54 connecting with the radiation shield 30, which as previously noted is thermally connected with the first stage 26 of the cryocooler 20. The plug 52 is axially aligned with the heat transfer device 54 along a length of the hollow support column 40. This alignment blocks the radiation window from the vacuum container 10 to the cryogenic structure 22 and provides a path for the radiation heat transfer from the vacuum container 10 (through the first cold stage 26 of the cryocooler 20).

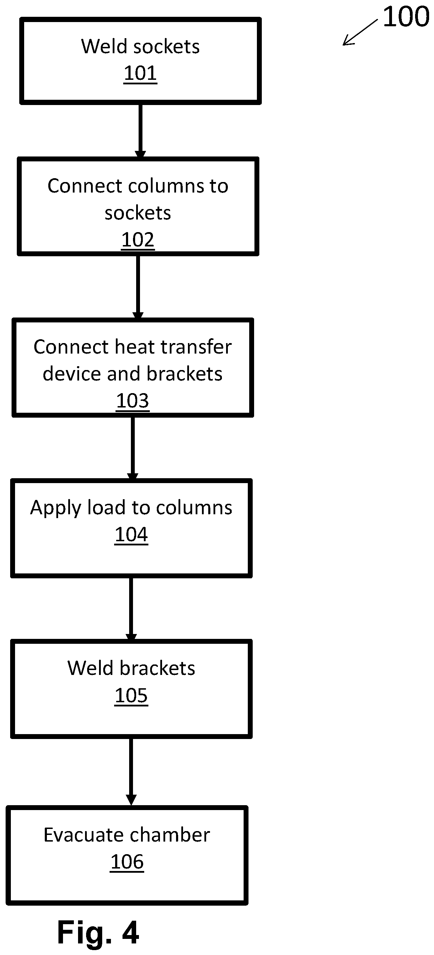

Fig. 4 shows a method 100 of assembling a magnetic resonance imaging (MRI) magnet comprising superconducting windings 12. To begin the method 100, at an operation 101, the sockets 42 are welded to the cryogenic structure 22. At an operation 102, the cryogenic structure 22 is disposed inside of the vacuum container 10 (which is at atmospheric pressure) with the support columns 40 are connecting the cryogenic structure 22 to the inner side wall SW of the vacuum container 10. At an operation 103, the heat transfer devices 54 are connected to the cryogenic structure 22 and the vacuum chamber 10, and the brackets 48 are placed onto the threaded ends 44 of the columns 40. At an operation 104, the compressive pre-load L is applied on the support columns 40. This can be performed by rotating each threaded socket 42 to engage the threaded end 44 of each support column 40. At an operation 105, the brackets 48 are welded to the inner side wall SW of the vacuum container 10. At an operation 106, the vacuum container 10 is evacuated to form a vacuum inside the vacuum container 10. A pressure difference between an outside of the vacuum container 10 and the vacuum inside the vacuum container 10 imposes a compressive load on the support columns 40.

The present disclosure, through one or more of its various aspects, embodiments and/or specific features or sub-components, is thus intended to bring out one or more of the advantages as specifically noted below. For purposes of explanation and not limitation, example embodiments disclosing specific details are set forth in order to provide a thorough understanding of an embodiment according to the present teachings. However, other embodiments consistent with the present disclosure that depart from specific details disclosed herein remain within the scope of the appended claims. Moreover, descriptions of well-known apparatuses and methods may be omitted so as to not obscure the description of the example embodiments. Such methods and apparatuses are within the scope of the present disclosure.

## Claims

1. A magnetic resonance imaging magnet, comprising:
a vacuum container (10);
a cryogenic structure (22) comprising superconducting windings (12), the cryogenic structure disposed inside the vacuum container; and
support columns (40) connecting the cryogenic structure to an inner side wall of the vacuum container.

2. The magnet of claim 1, wherein the support columns (40) are under a first compressive load (L) when an interior of the vacuum container (10) is at a vacuum pressure.

3. The magnet of claim 2, wherein the support columns (40) are under a second compressive load when the interior of the vacuum container (10) is at atmospheric pressure, the second compressive load being less than the first compressive load.

4. The magnet of claim 3, wherein a ratio of the first compressive load to the second compressive load is at least 1.5:1.

5. The magnet of any one of claims 1-4, wherein the cryogenic structure (22) has sockets (42) into which ends of the support columns (40) proximate to the cryogenic structure engage.

6. The magnet of claim 5, wherein the end proximate to the cryogenic structure (22) of each support column (40) comprises:
a cap (43) sized and dimensioned to fit into the corresponding socket (42) of the cryogenic structure.

7. The magnet of any one of claims 1-6, further comprising:
sockets (44) disposed on the inner side wall of the vacuum container (10);
wherein ends of the support columns (40) proximate to the inner side wall of the vacuum container have threads engaging the sockets.

8. The magnet of claim 7, further comprising:
brackets (48) mounted on the inner side wall of the vacuum container (10);
wherein the sockets (44) are rotatably mounted in the brackets.

9. The magnet of any one of claims 1-8, wherein each support column (40) is hollow.

10. The magnet of claim 9, wherein each hollow support column (40) includes a plug (52) disposed in a lumen (50) of the hollow support column to block radiative heat transfer through the lumen of the hollow support column.

11. The magnet of claim 1, further comprising:
a cryocooler (24) having a first cold stage (26) and a second cold stage (28), the second cold stage thermally connected to cool the cryogenic structure;
wherein each support column (40) includes a heat transfer device (54) disposed on an outer surface of the support column and thermally connected with the first cold stage of the cryocooler.

12. A method (100) of assembling a magnetic resonance imaging magnet (10), the method comprising:
with a vacuum container (10) at atmospheric pressure, disposing a cryogenic structure (22) comprising superconducting windings inside the vacuum container with support columns (40) connecting the cryogenic structure to an inner side wall of the vacuum container; and
evacuating the vacuum container to form a vacuum inside the vacuum container, wherein a pressure difference between an outside of the vacuum container and the vacuum inside the vacuum container imposes a compressive load on the support columns.

13. The method (100) of claim 12, further comprising:
prior to the evacuating, applying a compressive pre-load on the support columns (40), the compressive pre-load being less than the compressive load on the support columns imposed by the pressure difference between an outside the vacuum container (10) and the vacuum inside the vacuum container.

14. The method (100) of claim 13, wherein a ratio of the compressive load to the compressive pre-load is at least 1.5:1.

15. The method (100) of either one of claims 13 and 14, wherein the applying of the compressive pre-load on the support columns (40) comprises, for each support column, rotating a socket (44) mounted to the inner side wall of the vacuum container (10) to engage an end of the support column.
